(19) **Europäisches Patentamt / European Patent Office / Office européen des brevets**

(11) **EP 1 555 336 B1**

(12) **EUROPEAN PATENT SPECIFICATION**

(45) Date of publication and mention
of the grant of the patent:
**08.08.2007 Bulletin 2007/32**

(51) Int Cl.:
*C30B 15/10* (2006.01)  *C30B 29/06* (2006.01)

(21) Application number: **04029851.5**

(22) Date of filing: **16.12.2004**

(54) **Process for the growth of silicon crystal**

Verfahren zur Züchtung von Siliziumkristall

Procédé pour la croissance d'un cristal de silicium

(84) Designated Contracting States:
**DE**

(30) Priority: **26.12.2003 JP 2003435062**
**17.09.2004 JP 2004272074**

(43) Date of publication of application:
**20.07.2005 Bulletin 2005/29**

(73) Proprietor: **Siltronic AG**
**81737 München (DE)**

(72) Inventors:
• **Kishida, Yutaka**
**Hikari**
**Yamaguchi, 743-0011 (JP)**
• **Tamaki, Teruyuki**
**Hikari**
**Yamaguchi, 743-0012 (JP)**

(74) Representative: **Rimböck, Karl-Heinz et al**
**c/o Siltronic AG**
**Corporate Intellectual Property**
**Hanns-Seidel-Platz 4**
**81737 München (DE)**

(56) References cited:
DE-A1- 19 902 302          GB-A- 2 207 617
US-A- 5 567 399

• RICHTER: "Crystal growing crucible to suppress convection" N.T.I.S. TECH NOTES, 1986, pages 1115-1115, XP002330017 SPRINGFIELD,VA,USA

• GRABNER O ET AL: "Analysis of turbulent flow in silicon melts by optical temperature measurement" MATERIALS SCIENCE AND ENGINEERING B, ELSEVIER SEQUOIA, LAUSANNE, CH, vol. 73, no. 1-3, April 2000 (2000-04), pages 130-133, XP004192034 ISSN: 0921-5107

• PATENT ABSTRACTS OF JAPAN vol. 008, no. 052 (C-213), 9 March 1984 (1984-03-09) & JP 58 208193 A (HITACHI SEISAKUSHO KK), 3 December 1983 (1983-12-03)

• PATENT ABSTRACTS OF JAPAN vol. 018, no. 395 (C-1229), 25 July 1994 (1994-07-25) & JP 06 114192 A (DAIKEN PLAST KK), 26 April 1994 (1994-04-26)

• PATENT ABSTRACTS OF JAPAN vol. 1999, no. 09, 30 July 1999 (1999-07-30) & JP 11 092272 A (KOMATSU ELECTRON METALS CO LTD), 6 April 1999 (1999-04-06)

• PATENT ABSTRACTS OF JAPAN vol. 013, no. 063 (C-568), 13 February 1989 (1989-02-13) & JP 63 256593 A (OSAKA TITANIUM SEIZO KK; others: 01), 24 October 1988 (1988-10-24)

• PATENT ABSTRACTS OF JAPAN vol. 1995, no. 02, 31 March 1995 (1995-03-31) & JP 06 321678 A (KAWASAKI STEEL CORP), 22 November 1994 (1994-11-22)

• KAKIMOTO K: "Flow instability during crystal growth from the melt" PROGRESS IN CRYSTAL GROWTH AND CHARACTERIZATION OF MATERIALS, ELSEVIER PUBLISHING, BARKING, GB, vol. 30, no. 2, 1995, pages 191-215, XP004048547 ISSN: 0960-8974

**Description**

The present invention relates to a process for the growth of silicon crystal which can enhance the productivity, yield and quality of crystal by inhibiting the deformation of growing crystal in the process of silicon crystal growth by Czochralski method.

As substrates for the production of electronic elements or photoelectronic elements there have been used various elementary semiconductor crystals and compound semiconductor crystals. As a method for the production of these crystals there is used Czochralski method (CZ method). CZ method is a favourable method for the production of large-sized crystals. Silicon crystal, which is the mainstream in semiconductor electronic elements of today, is mostly produced by CZ method.

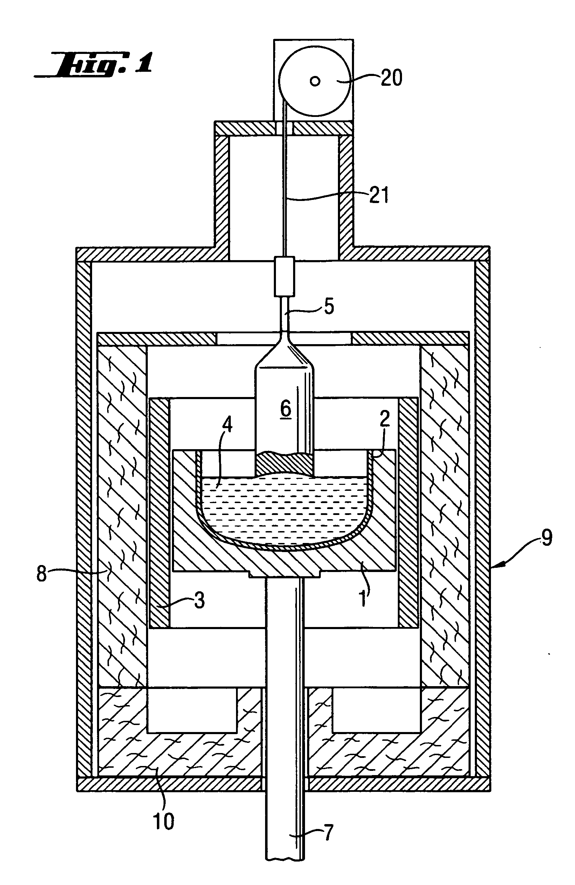

Fig. 1 is a typical longitudinal section of a CZ method crystal producing furnace. In this furnace, a crucible 2 received in a susceptor 1 placed on a rotatable crucible shaft 7 which can ascent and descent is filled with a raw crystal material which is then heated and melted by a heater 3 to obtain a molten liquid 4. On the other hand, on the top of the furnace is provided a mechanism 20 for pulling the crystal upward while rotating the crystal. A seed crystal 5 connected to this mechanism is dipped in the molten liquid 4. Thereafter, the seed crystal 5 is pulled upward while the seed crystal 5 and the crucible 1 are being rotated in opposite directions to cause the growth of a pillar crystal 6.

In CZ method, the crystal growth interface is a free end to cause the growth of crystal from the free surface of the molten liquid. A pillar crystal can be grown by properly disposing the heating member in the furnace or properly rotating the crystal or crucible such that the temperature distribution in the vicinity of the crystal is symmetrical about the axis. However, when the crystal growth rate is raised, the resulting crystal undergoes spiral or petal-shaped deformation, causing drop of yield in crystal form. Further, the resulting interface deformation is accompanied by local drop of surface tension that causes the crystal to be separated from the level of the molten liquid. Moreover, when the crystal growth rate is raised, the resulting crystal can come in contact with the wall of the crucible or the furnace member disposed above the level of the molten liquid and then fall. Thus, it has been difficult to raise the crystal growth rate beyond a certain value.

The upper limit of the crystal growth rate does not only prevent the productivity of crystal but also affect the quality of crystal. Referring to monocrystalline silicon for semiconductor substrate in particular, the amount of microdefects is governed by the ratio V/G of the crystal growth rate V to the temperature gradient G on the growth interface in the direction of crystal growth. When the crystal growth is effected at a V/G ratio of less than critical value, the yield of good products is drastically impaired (see Non-patent Reference 1).

The reason for the crystal deformation accompanying the rise of crystal growth rate is not yet made obvious. It has been well known that some improvements can be made by devising the furnace members disposed above the level of the molten liquid such that the growing crystal can be sufficiently cooled. To this end, many techniques such as provision of water cooling pipe near the growing crystal have been proposed (see Patent References 1, 2 and 3).

> Patent Reference 1 JP-A-63-256593
> Patent Reference 2 JP-A-8-239291
> Patent Reference 3 JP-A-11-92272
> Non-patent Reference 1 "Shin-nittetsu Giho", No. 373, September 29, 2000, page 2

By making a device such that the growing crystal can be sufficiently cooled, the crystal growth rate can be somewhat raised. However, as the crystal growth rate increases, the resulting crystal undergoes deformation, making it impossible to form a crystal having a desired shape. The fact that the limitation of crystal growth rate is attributed to crystal deformation rather than to separation of crystal from molten liquid means that this problem arises due to instabilization of crystal growth interface on the periphery of crystal rather than ill heat balance caused by too high a crystal growth rate as compared with crystal cooling rate. It can be presumed that the cause of the instability of growth interface has something to do with the change of temperature gradient in the radial direction of crystal. However, since the relationship between the crystal growth rate and the temperature gradient on the peripheral growth interface has not been well made obvious, no effective measure for coping with crystal deformation has ever been obtained.

It has been proposed to suppress non-uniform crystal growth by providing a platform or a spigot mounted onto the bottom wall of the crucible directly below the growing crystal (GB2207617A; R. Richter, "Crystal-Growing Crucible To Suppress Convection", 2301 N.T.I.S Tech Notes, October 1986, Springfield, VA, USA). The platform or spigot restricts the depth of the melt below the growing crystal to a value small enough to completely suppress convection below the crystal. DE19902302A1 also discloses a crucible having a convex protrusion at its bottom wall. The protrusion is designed to receive an ultrasound transmitter from below.

The present inventors made an analytical study of cause of crystal deformation occurring during the growth of silicon crystal by CZ method paying their attention to numerical simulation and vortex characteristic to flow. As a result, it was found that the deformation of crystal caused by the rise of crystal growth rate is greatly affected by the profile of growth interface expanding drastically in the crystal growth direction characteristic to silicon crystal and the vertical thickness between crystal and the bottom of the crucible.

The invention defined in Claim 1 concerns a process for the growth of a silicon crystal by the Czochralski method which comprises using a crucible having an inner bottom surface the profile of which has at least a raised portion symmetrical about the rotation axis of the crucible wherein the periphery of the raised portion is positioned at a distance from the rotation axis of from 0.4 to 1.2 times the radius of the crystal to be grown and wherein the height of the raised portion is from not smaller than 7% to not greater than 100 % of the radius of the crystal to be grown. The mechanism of the arrangement will be further described hereinafter.

A molten liquid which is growing to crystal by CZ method is given an angular momentum by the rotation of the crucible and the rotation of crystal. The crucible has a far greater contact area with the molten liquid and radius of rotation than crystal. Therefore, the majority of the molten liquid rotates at substantially the same speed as the crucible. Only the portion of the molten liquid in the vicinity of the crystal growth interface rotates at substantially the same speed as crystal (see AWD Jones, "J. Crystal Growth", 88, (1988), page 465).

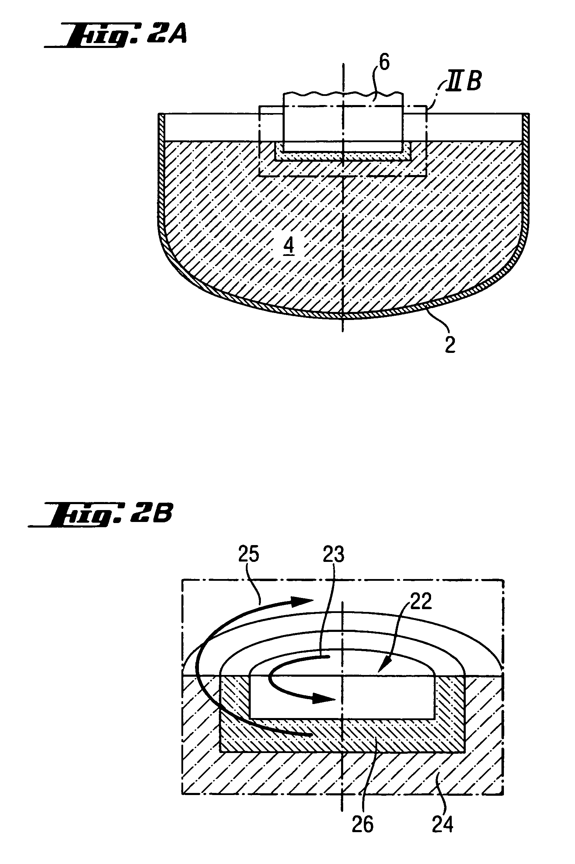

Fig. 2A illustrates the flow structure of a molten liquid in a crucible for the growth of crystal by CZ method. As shown in the enlarged view (Fig. 2B), a molten liquid in a crucible by CZ method can fluidynamically divided into three regions.

The first region is a Cochran boundary layer shown by the reference numeral 22. This is a thin layer which is disposed right under the crystal and rotates in the direction shown by the arrow 23 at substantially the same speed as the crystal. The thickness of this layer is extremely small. In the case of molten silicon, the thickness of this layer falls below 1 mm. This layer has a great rotation moment and thus is relatively stable and shows a small flow disturbance.

The second region is a rigid body rotation region shown by the reference numeral 24. This layer in the second region undergoes thermal convection caused by heating by heater and hence much flow disturbance. In ordinary CZ method, however, the rotation speed of the crucible is sufficiently greater than the speed of convection or resulting disturbance. It is therefore thought that this layer rotates together with the crucible in the direction shown by the arrow 25. Accordingly, the vorticity vector of the molten liquid in this region extends substantially along the rotation axis and the vortex extends from the bottom of the crucible to the surface of the molten liquid almost vertically.

The third region is a disc-shaped interlayer region shown by the reference numeral 26 which is disposed interposed between the Cochran boundary layer 22 and the rigid body rotation region 24. It is thought that the thickness of this region is as small as several times that of the Cochrane border layer 22 and the radial dimension of this region is about 1.2 times or less the radius of the crystal. This region is acted upon by concentrated shearing force developed both by the rotation of the crystal and the crucible and thus exhibits a high Reynolds number. This means that the flow of molten liquid can be easily disturbed in this region.

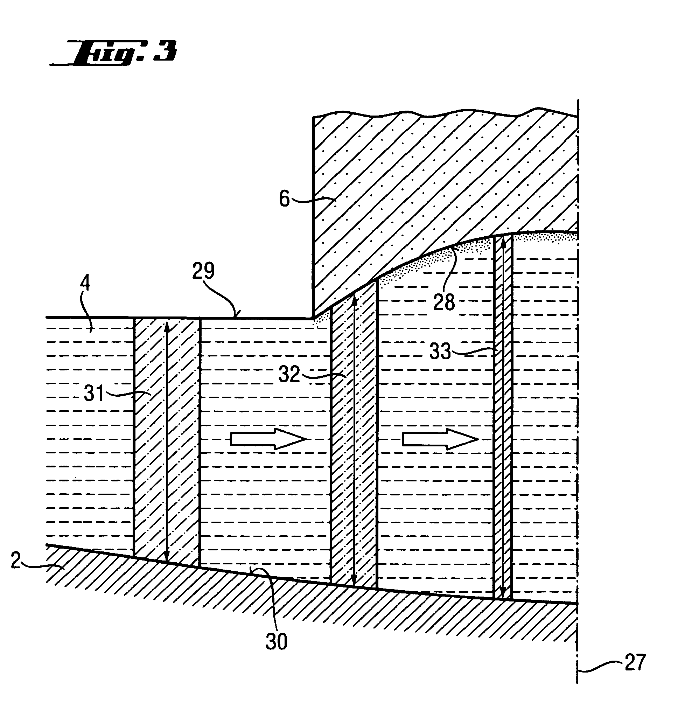

The mechanism of the movement of the vortex tube formed by fluctuations such as thermal convection in the rigid body rotation region outside the crucible to the lower portion of the crystal growth interface in a molten liquid of CZ method under the aforementioned conditions will be described in connection with Fig. 3.

Fig. 3 is a typical illustration of the change of the thickness of a molten liquid and the change of the length of a vortex in a CZ method crucible for the growth of silicon crystal on the left side of the central axis 27 of a crystal 6.

The growth interface of silicon crystal in CZ method normally expands upward (in the direction of crystal growth). Therefore, in the case of a commonly used crucible the inner bottom surface of which is spherical, the vertical distance between the crystal growth interface and the inner bottom surface of the crucible increases from the periphery of the crystal toward the central axis of the crystal. When fluctuations such as thermal convection cause a vertically standing vortex tube 31 to enter the crystal from its outside toward the center thereof, the length of the vortex tube increases as shown by vortex tubes 32, 33. As the length of the vortex tube increases, the speed of the rotation of the molten liquid in the vortex tube increases according to the vortex conservation laws. At this point, the lower portion of the interlayer is acted upon by a great shearing force caused by the extension of vortex. Thus, the flow of the molten liquid in the lower portion of the interlayer becomes unstable.

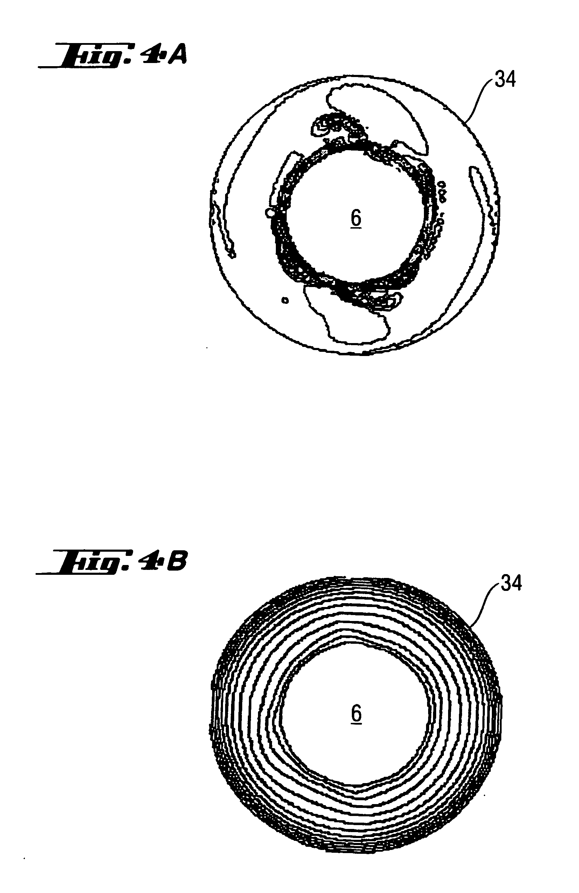

Fig. 4A illustrates a pattern of vortex distribution on the molten liquid surface during the growth of silicon crystal obtained by numeral simulation. Fig. 4B illustrates a pattern of temperature distribution on the molten liquid during the growth of silicon crystal obtained by numeral simulation. In these figures, the reference numeral 6 indicates a crystal and the reference numeral 34 indicates the side wall of the crucible 2.

A circumferentially wavy vortex as shown in Fig. 4A is formed particularly on the periphery of the crystal. At the same time, a circumferentially wavy distorted temperature distribution occurs as shown in Fig. 4B. this temperature distribution has a direct effect on the profile of the crystal growth interface, causing crystal deformation. Further, the circumferentially wavy disturbance accelerates the transportation of heat in the radial direction, causing a drastic reduction of radial temperature gradient dT/dR of the crystal growth interface. The smaller dT/dR is, the greater is the degree of freedom of crystal deformation, that is, the more easily can occur crystal deformation.

In order to actually ascertain the aforementioned theory, numerical flow simulation was made on the sectional profile of the crystal interface in terms of a trigonometric function having a period of 1/2 expanding at an amplitude H in the direction of crystal growth supposing silicon crystal growth at a high speed. As a result, the relationship between the circumferential average of the temperature gradient dT/dR of the surface of the molten liquid in contact with the periphery of the crystal and H which is the height of the expansion of the crystal was found as set forth in Table 1. In Table 1, H is represented relative to the radius of the crystal as 1. In this numerical flow simulation, it is supposed that the Taylor number of the molten liquid during the rotation of the crucible be $1 \times 10^{10}$, the radius of the crystal be half that of the crucible and the crystal be rotated at a speed as much as twice that of the crucible in the direction opposite that of the crucible. Since the molten liquid in the crucible forms a cylindrical region having an aspect ratio of 6, H in this simulation corresponds to the extension of the vortex tube over the range from the end to the center of the crystal.

Table 1: Relationship between the expansion of the crystal interface in the direction of crystal growth and the radial temperature gradient of the molten liquid at the periphery of the crystal obtained in numerical flow simulation (H is represented relative to the radius of crystal as 1)

|  | Condition 1 | Condition 2 | Condition 3 | Condition 4 |
|---|---|---|---|---|
| Expansion H of crystal interface in the crystal growth direction | - 0.1 | 0 | 0.1 | 0.2 |
| Radial temperature gradient dT/dR (°C/min) of surface of molten liquid at periphery of crystal | 1.50 | 1.35 | 1.15 | 0.83 |

As can be seen also in numerical simulation, dT/dR, which is an index of stability to crystal deformation, decreases with the increase of the expansion of crystal interface (i.e., vertical thickness of the molten liquid). This gives a presumption that the crystal deformation is attributed to the expansion and contraction of vortex under the crystal growth interface.

The present inventors proposed the formation of the profile of the bottom of the crucible for use in crystal growth for the purpose of inhibiting the deformation of silicon crystal on the basis of the aforementioned consideration and results of simulation.

Judging from the aforementioned consideration, the profile of the bottom of the crucible may be arranged such that the vertical thickness of the molten liquid layer taking into account the expanded shape of the interface of the molten liquid layer doesn't increase the toward the central axis of the crucible because it is essential that the length of the vortex in the region where the crystal form can be thought to be affected through the interlayer be reduced toward the center of the crucible. Further, on the other hand, since the molten silicon is a viscous fluid, the desired effect can be expected even if the profile of the bottom of the crucible deviates somewhat from the above defined arrangement. Accordingly, it is thought that an effect of increasing dT/dR can be exerted so far as the bottom of the crucible expands in the direction of crystal growth to form a raised portion the radius of which is not more than 1.2 times that of the crystal to be grown.

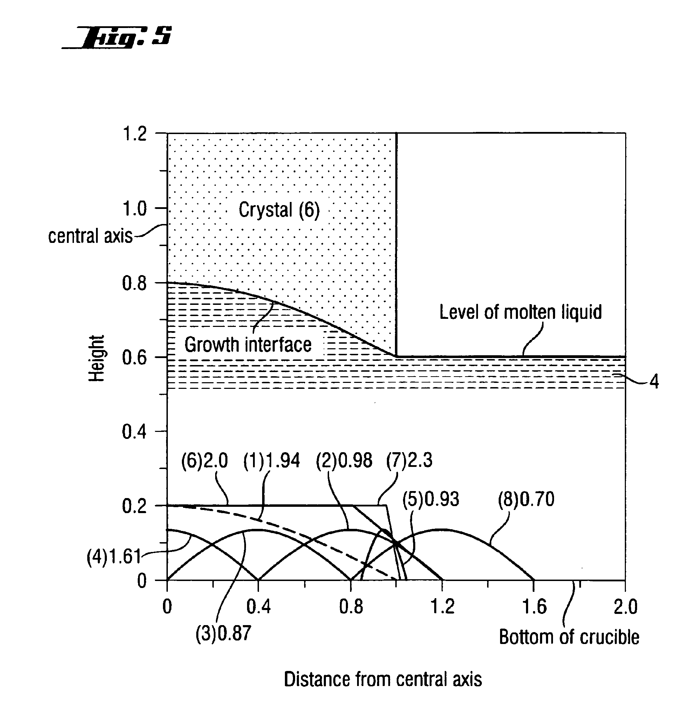

In order to confirm this effect, eight types of profile of crucible bottom as described below and as shown in Fig. 5 were subjected to numerical simulation of flow of molten liquid supposing the profile of crystal interface of Condition 4 set forth in Table 1 to study the effect of profile of crucible bottom on dT/dR.

Type (1): Crucible the profile of bottom of which is the same as that of the crystal growth interface;
Type (2): Crucible having a half torus raised portion having a height of 0.13 times the radius of crystal to be grown over a section of from 0.4 to 1.2 times the radius of crystal surrounding the rotation axis of the crucible;
Type (3): Crucible having a half torus raised portion having a height of 0.13 times the radius of crystal to be grown over a section of up to 0.8 times the radius of crystal surrounding the rotation axis of the crucible;
Type (4): Crucible having a half torus raised portion having a height of 0.13 times the radius of crystal to be grown over a section of up to 0.4 times the radius of crystal surrounding the rotation axis of the crucible;
Type (5): Crucible having a half torus raised portion having a height of 0.13 times the radius of crystal to be grown over a section of from 0.85 to 1.05 times the radius of crystal surrounding the rotation axis of the crucible;
Type (6): Crucible having a truncated cone-shaped raised portion having a height of 0.2 times the radius of crystal to be grown over a section of from 0.8 to 1.2 times the radius of crystal surrounding the rotation axis of the crucible;
Type (7): Crucible having a truncated cone-shaped raised portion having a height of 0.2 times the radius of crystal to be grown over a section of from 0.95 to 1.05 times the radius of crystal surrounding the rotation axis of the crucible; and

Type (8): Crucible having a raised portion having a height of 0.13 times the radius of crystal to be grown over a section of from 0.8 to 1.6 times the radius of crystal surrounding the rotation axis of the crucible

The results of the radial temperature gradient (dT/dR) of the surface of the molten liquid at the periphery of the crystal obtained by simulation made on the crucibles of the aforementioned Types (1) to (8) are as set forth in Table 2 below. For comparison, Table 2 also contains the results of a crucible having a plain bottom surface (same as Condition 4 in Table 1) as Type (0).

Table 2 shows the value of dT/dR obtained by numerical simulation made on the various types of crucible profiles (The numerical value of position and height are represented relative to the radius of crystal as 1).

Table 2

| Profile of crucible | Position of inner end of raised portion | Position of outer end of raised portion | Position of top of raised portion | Height of raised portion | Radial temperature gradient of surface of molten liquid at periphery of crystal (dT/dR (°C/mm)) | Increase of dT/dR relative to Type (0) |
|---|---|---|---|---|---|---|
| Type (1) | 0.0 | 1.0 | 0.5 | 0.20 | 1.94 | 2.3 times |
| Type (2) | 0.4 | 1.2 | 1.0 | 0.13 | 0.98 | 1.18 times |
| Type (3) | 0.0 | 0.4 | 0.2 | 0.13 | 0.87 | 1.04 times |
| Type (4) | 0.0 | 0.4 | 0.0 | 0.13 | 1.61 | 1.94 times |
| Type (5) | 0.85 | 1.05 | 0.95 | 0.13 | 0.93 | 1.12 times |
| Type (6) | 0.0 | 1.2 | 0.0 ~ 0.8 | 0.20 | 2.00 | 2.4 times |
| Type (7) | 0.0 | 1.05 | 0.0 ~ 0.95 | 0.20 | 2.30 | 2.7 times |
| Type (8) | 0.8 | 1.6 | 1.2 | 0.13 | 0.70 | 0.8 times |
| Type (0) | - | - | - | 0% | 0.83 | - |

As can be seen in the results of Table 2, the crucibles of Types (1) to (7), the profile of the inner bottom surface of which is arranged to have a raised portion having a radius of 1.2 times or less that of the crystal to be grown with respect to the rotation axis of the crucible, has an effect of increasing dT/dR at the periphery of the crystal. On the contrary, the crucibles having a raised portion on the bottom thereof at a position which is not under the crystal as in Type (8) has an effect of decreasing dT/dR rather than increasing dT/dR.

It was also made obvious that the crucibles of Types (6) and (7), the depth of which at the edge of crystal shows a great change, have dT/dR which increases even when the thickness of the molten liquid at the center of the crystal growth interface increases toward the central axis of the crucible.

In the present invention, the crucible has a raised portion formed on the inner bottom surface thereof. It is thought that the effect of the present invention differs with the height of the raised portion. The effect of the present invention can be judged by comparing the value of dT/dR thus obtained with that obtained with a crucible having a plain inner bottom surface free of raised portion wherein the crystal growth interface is plain (free of upward raised portion).

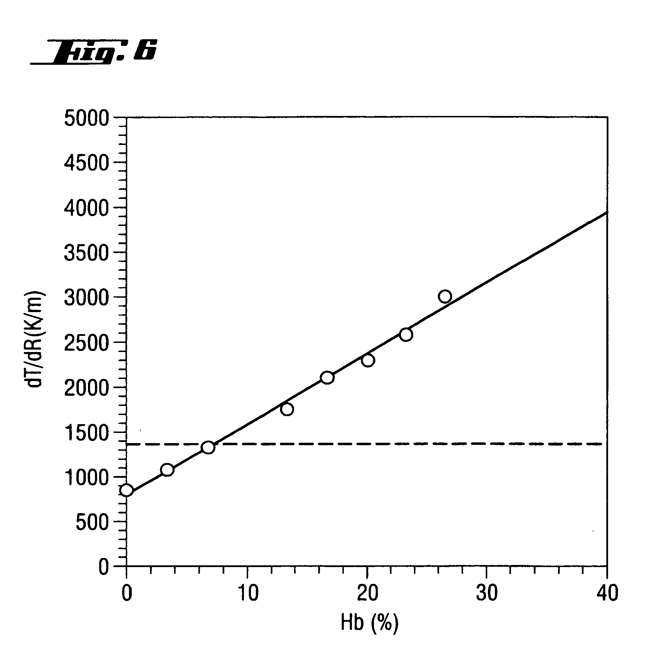

Fig. 6 indicates the relationship between dT/dR and height Hb of raised portion determined on a crucible of Type (7) having different heights of raised portion by numerical simulation. In Fig. 6, Hb is represented by percentage to the radius of the crucible. For reference, the value of dT/dR (1.35°C/mm) determined on the growth of crystal having a plain interface using a crucible having no raised portion on the bottom thereof by numerical simulation is shown by a dotted line.

As can be seen in Fig. 6, dT/dR increases in substantial proportion to the height of the raised portion and when Hb is greater than 7% of the radius of the crystal, dT/dR exceeds 1.35°C/mm, demonstrating that when Hb is greater than 7% of the radius of the crystal, the effect of the present invention can be exerted.

It is thought that the higher the height Hb of the raised portion is, the greater is dT/dR and the greater is the effect of the present invention. However, when Hb is great, the molten liquid disposed at a position lower than the top of the raised portion on the bottom cannot be crystallized in the actual operation, causing the waste of the material in that amount. When the height of the raised portion is greater than the radius of the crystal in the crucible, the wasted amount of the molten liquid exceeds the wasted amount of tail portion or conical portion of the crystal to disadvantage from the economical standpoint of view.

As mentioned above, the crucible defined in Claim 1 has an inner bottom surface the profile of which has one or more raised portions symmetrical about the rotation axis of the crucible wherein the raised portions are positioned at a distance of from 0.4 to 1.2 times the radius of crystal to be grown from the rotation axis and the height of the raised portions is from not smaller than 7% to not greater than 100% of the radius of crystal to be grown as in those of the aforementioned Types (1) to (7).

The invention defined in Claim 2 is characterized in that the inner bottom surface of the crucible is arranged over a section disposed at a distance of from at least 0.8 to 1.2 times the radius of crystal to be grown from the rotation axis such that the vertical thickness of a molten liquid layer taking into account the expanded shape of the interface of the molten liquid layer with crystal during the growth of regular shape portion of crystal doesn't increase toward the central axis of the crucible wherein the inner bottom surface thereof has a raised portion formed thereon having a height of not greater than half the radius of crystal to be grown as in those of the aforementioned Types (2), (3), (5), (6) and (7).

In this arrangement, the depth of the molten liquid layer doesn't increase over a section of from 0.8 to 1.2 times the radius of the crystal to be grown but decreases (progressively or monotonously) toward the center of the crucible over at least a part of the section. Of course, the depth of the molten liquid layer may decrease over the entire section of from 0.8 to 1.2 times the radius of the crystal to be grown. Accordingly, the bottom of the crucible may be formed such that the thickness of the molten liquid decreases monotonously over a section of from 1.0 to 1.2 times the radius of the crystal to be grown but remains substantially constant over a section of from 0.8 to 1.0 times the radius of the crystal to be grown. Alternatively, the bottom of the crucible may be formed such that the thickness of the molten liquid increases over a section of from 0.9 to 1.3 times the radius of the crystal to be grown but remains substantially constant over a section ranging from 0.9 times the radius of the crystal to be grown to the central axis of the crucible. On the contrary, the bottom of the crucible may be formed such that the thickness of the molten liquid remains substantially constant over a section of from 1.0 to 1.3 times the radius of the crystal to be grown but decreases over a section of from 1.0 to 1.7 times the radius of the crystal to be grown or a section ranging from 1.0 time the radius of the crystal to be grown to the central axis of the crucible. In other words, it suffices in the invention defined in Claim 2 if the thickness of the molten liquid doesn't increase toward the centre of the crucible over a section of from 0.8 to 1.2 times the radius of the crystal to be grown or part thereof. In this arrangement, the thickness of the molten liquid doesn't increase and there is no expansion or contraction of vortex toward the centre of the crucible, causing no crystal deformation over a section of at least from 0.8 to 1.2 times the radius of the crystal to be grown.

The invention defined in Claim 3 uses the crucible of Claim 2 wherein the inner bottom surface thereof is arranged over a section ranging from the radius of the crystal to be grown to the centre of rotation such that the height of the inner bottom surface doesn't decrease toward the central axis to prevent the increase of the extension of the vortex under the centre of the crystal and the height of the raised portion formed on the inner bottom surface thereof is not greater than half the radius of crystal to be grown. This arrangement corresponds to the crucibles of the aforementioned Types (6) and (7). In this arrangement, an effect of increasing dT/dR more than the crucible of Type (3), which doesn't correspond to the invention of Claim 3 but the invention of Claim 2, can be exerted, making it possible to inhibit crystal deformation more effectively.

In order to design the profile of the bottom of crucible according to the inventions of Claims 1 to 3, it is necessary to know the internal profile of the crystal during the growth of regular shape portion. The internal profile of the crystal during the growth of regular shape portion can be confirmed by the profile of a striation pattern obtained by visualization of a section of a crystal grown in a crucible having a conventional shape by X-ray topography.

According to the invention defined in any one of Claims 1 to 3, a crystal having a good quality can be grown at a high rate.

The concept of the present invention is based on the assumption that the vortex in the rigid body rotation region extends vertically. However, there is a case where when thermal convection occurring in the crucible causes the direction of the vortex to deviate from the vertical direction, the effect of the present invention is weakened. In this respect, since it is known that the vertical component of the flow in a rotating vessel is suppressed by the action of Coriolis force accompanying the rotation (see Toru Yoshizawa, "Ryutai Rikigaku (Fluidynamics)", Tokyo Daigaku Shuppankai, September 5, 2001, page 75), the present inventors thought that stronger action of Coriolis effect makes it possible to keep the axis of vortex in the molten liquid vertical and hence exert the effect of the present invention more strongly.

Accordingly, the invention defined in Claim 4 is characterized in that the crucible for the growth of crystal defined in any one of Claims 1 to 3 is used whereby the rotation speed of the crucible during crystal growth is predetermined such that the Taylor number of the molten liquid is not smaller than $1.0 \times 10^9$.

Taylor number is a dimensionless number that quantifies the intensity of Coriolis force acting on a molten liquid. It is defined by the following relationship:

$$Ta = 4\Omega^2 R^4 / \nu$$

wherein $\Omega$ represents the angular velocity of rotation of the crucible; R represents the radius of the crucible; and $\nu$ represents the dynamic viscosity coefficient of the raw molten liquid.

As mentioned above, in accordance with the present invention, when a vortex in the molten liquid enters right under the crystal, the flow on the side of the crystal growth interface can be kept stable without causing the rotation of the vortex tube to be accelerated according to the vortex tube conservation laws. Further, the temperature distribution on the periphery of the crystal growth interface can be stabilized to inhibit the deformation of growing silicon crystal, making it possible to enhance the productivity of crystal and hence the quality of crystal.

Further, in accordance with the present invention, the rate of crystal growth can be raised by controlling the rotation speed of the crucible during crystal growth such that the Taylor number of the molten liquid is not smaller than $1.0 \times 10^9$.

Example

The present invention will be further described in the following examples in connection with the attached drawings.

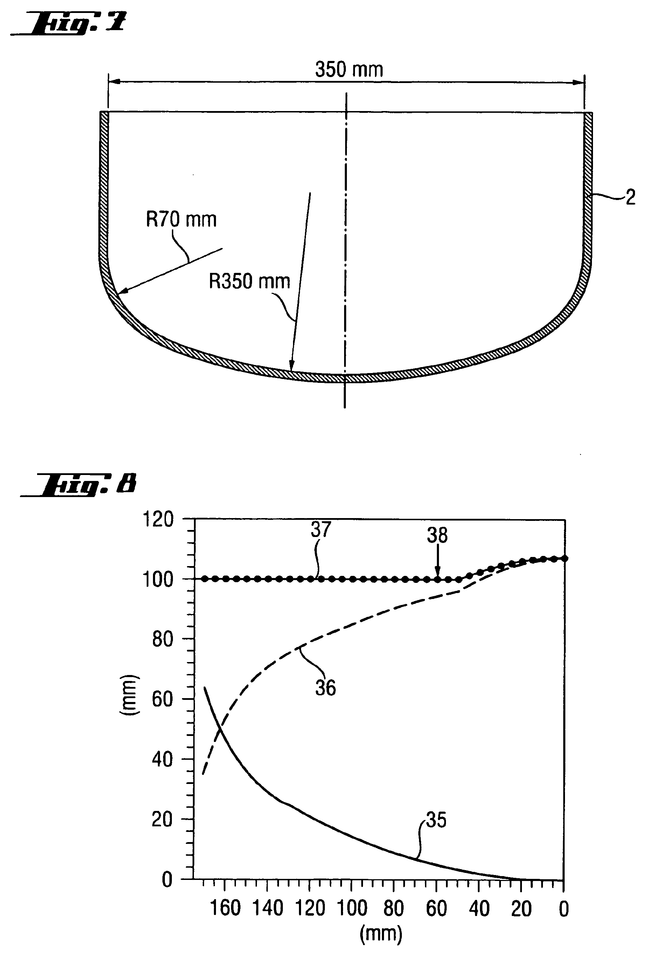

Fig. 7 illustrates the profile of a section of a typical crucible made of quartz having an aperture of 350 mm for use in the production of silicon crystal in the state-of-the-art. This crucible is formed by a vertically extending cylindrical outer wall having an inner diameter of 350 mm and a spherical bottom portion having a radius of 350 mm which are inscribed in an arc wall having a radius of 70 mm.

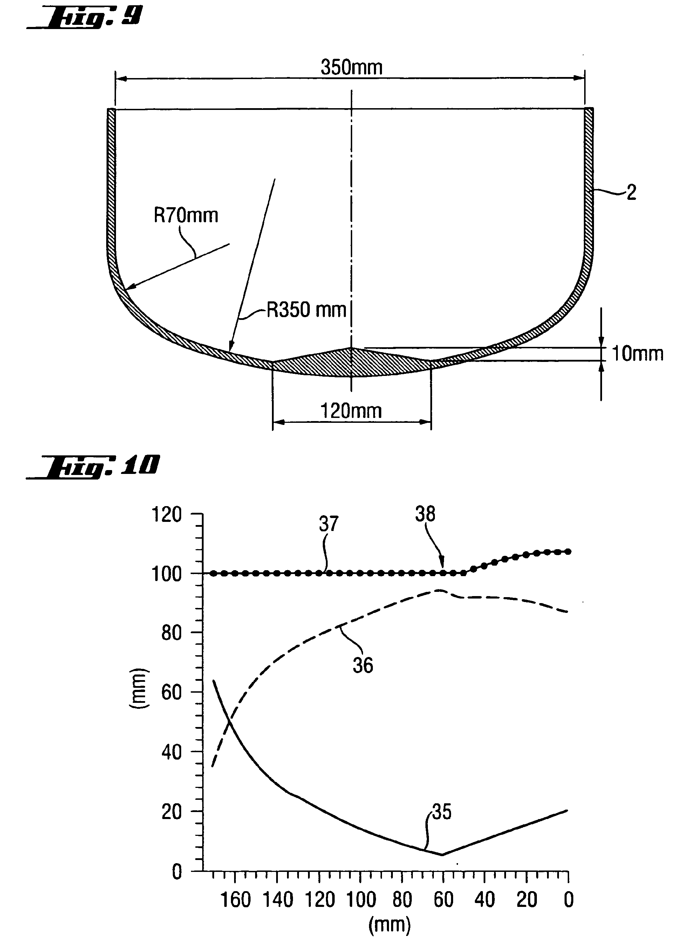

Fig. 8 illustrates the change of the vertical length of the molten liquid layer over a section ranging from the position of the outer wall of the crucible to the position of the central axis in the case of growth of a crystal having a diameter of 100 mm using this crucible with the change of the profile of growth interface during the growth of regular shape portion of crystal and the profile of the bottom of the crucible.

In Fig. 8, with height in mm as ordinate and distance from the central axis of the crucible in mm as abscissa, the height of the inner bottom surface of the crucible extending radially from the central axis of the crucible is shown by the solid line 35, the thickness of the molten liquid layer is shown by the broken line 36, the height of the level of the molten liquid and the crystal growth interface is shown by the dotted line and the position of the periphery of the crystal is shown by the reference numeral 38. As can be seen in Fig. 8, the vertical length of the molten liquid layer increases monotonously from the periphery of the crucible toward the central axis of the crucible.

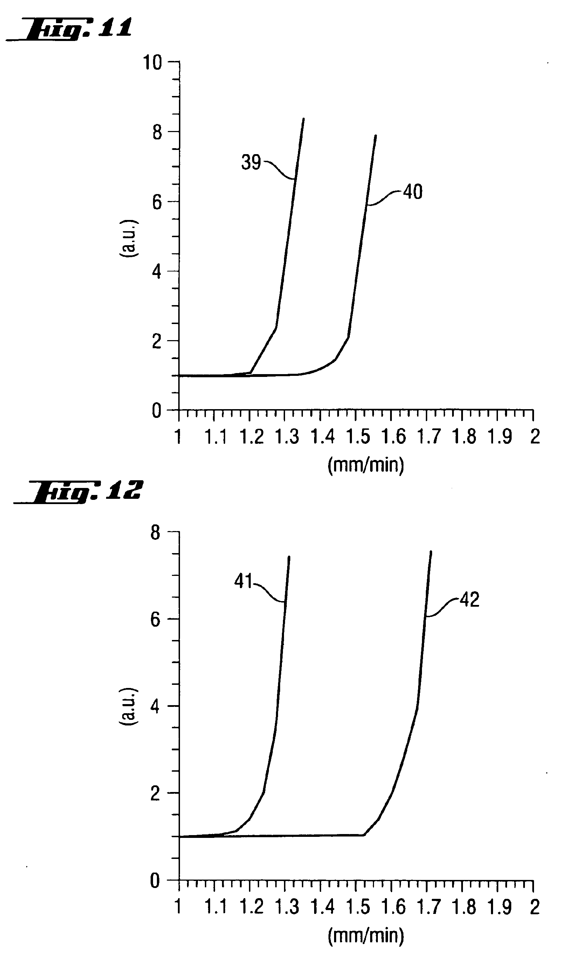

Fig. 9 is a longitudinal sectional view illustrating a first embodiment of the crucible of the present invention made of quartz for use in the growth of silicon crystal. This crucible is adapted for the growth of a crystal having a diameter of 100 mm and has the same outer shape as that of Comparison Example 1 shown in Fig. 7 but has a low conical bottom having a height of 10 mm over a section ranging from the center of the bottom of the crucible to a radius of 60 mm.

Fig. 10 illustrates the change of the vertical thickness of the molten liquid over a section ranging from the periphery of the crucible to the central position of the crucible in the case of growth of a crystal having a diameter of 100 mm using the crucible shown in Fig. 9 with the change of the profile of growth interface of regular shape portion of crystal and the profile of the bottom of the crucible. In Fig. 10, too, with height in mm as ordinate and distance from the central axis of the crucible in mm as abscissa, the height of the inner bottom surface of the crucible extending radially from the central axis of the crucible is shown by the solid line 35, the thickness of the molten liquid layer is shown by the broken line 36, the height of the level of the molten liquid and the crystal growth interface is shown by the dotted line and the position of the periphery of the crystal is shown by the reference numeral 38. The vertical thickness of the molten liquid layer increases monotonously from the position corresponding to the radius of 175 mm toward the center of the crucible to the position corresponding to the radius of 60 mm, which is 1.2 times the radius of the crystal but remains substantially constant over a section ranging from the position corresponding to the radius of 50 mm of the crystal to the position corresponding to the radius of 40 mm, which is 0.8 times the radius of the crystal. In other words, in accordance with the present invention, the crucible is arranged such that the vertical thickness of the molten liquid layer taking into account the shape of the upward expansion of the molten liquid interface at the central part of the crystal during the growth of regular shape portion of crystal doesn't increase toward the center of the crucible over a section between the positions at which the distance from the central axis of rotation of crucible is at least 0.8 to 1.2 times the radius of the crystal to be grown. While the present embodiment has been described with reference to the case where the inner bottom surface of the crucible is formed conical such that the thickness of the molten liquid layer decreases progressively from the position corresponding to 30 mm, which is 0.6 times the radius of the crystal to be grown, toward the center of the crystal, the inner bottom surface of the crucible may be formed in truncated cone or so-called folded double cone which is a cone having its top folded backward so that the thickness of the molten liquid layer doesn't increase toward the center of the crucible, that is, the thickness of the molten liquid layer remains constant or decreases monotonously toward the center of the crucible.

Figs. 11 and 12 are diagrams illustrating the relationship between the rate of crystal growth and the width of deformation of crystal in the case where the ordinary crucible of Comparison Example 1 shown in Fig. 7 and the crucible of the inventive example shown in Fig. 9 are used, respectively. In these figures, growth rate is plotted in mm/min as abscissa and width of deformation is plotted in arbitrary unit as ordinate. The width of deformation of crystal is determined by taking the difference between the maximum and minimum values of the position of the periphery of crystal developed when the crystal makes one rotation, and then subjecting the difference to calculation by an image processor.

Figs. 11 and 12 each illustrate the relationship between the pulling rate and the change of crystal radius developed when a crystal having a diameter of 100 mm is grown from 40 kg of a material dissolved in the respective crucible at gradually changing rate while being rotated at a constant crystal rotation speed of 15 rpm.

Fig. 11 shows the results obtained by rotating the crucible at a constant rate of 1.8 rpm with the Taylor number of the molten liquid kept at $9.20 \times 10^8$ wherein Comparison Example 1 is shown by the curve 39 and the inventive example is shown by the curve 40. In the case of crystal growth using the crucible having an ordinary structure of Comparison Example 1, when the pulling rate was 1.2 mm/min or more, crystal deformation began and the amplitude of diameter change rapidly increased, making it necessary to reduce the pulling rate. On the other hand, the crucible having the inventive bottom profile caused no crystal deformation even when the pulling rate was raised to 1.2 mm/min. When the pulling rate was raised to 1.4 mm/min, crystal deformation began and a great diameter change occurred. In other words, the use of the crucible having the inventive structure allows high speed crystal growth without causing crystal deformation.

Fig. 12 shows the results of tests made in the same manner as mentioned above except that the rotation speed of the crucible was predetermined higher such that the Taylor number of the molten liquid in the crucible is $3.0 \times 10^9$. In Fig. 12, the results of the use of the crucible having an ordinary structure of Comparison Example 1 shown in Fig. 7 are shown by the curve 41 and the results of the use of the crucible having the inventive structure of Example 1 shown in Fig. 8 are shown by the curve 42. The inventive crucible satisfies the requirements of Claim 3.

In the case of the ordinary crucible of Comparison Example 1, when the pulling rate was 1.1 mm/min or more, crystal deformation occurred to cause drastic increase of the amplitude of diameter change, making it necessary to reduce the pulling rate. In the case of the crucible having the inventive structure, on the other hand, no crystal deformation occurred even when the pulling rate was raised to 1.4 mm/min. The crystal diameter began to change when the pulling rate was raised to 1.5 mm/min. In other words, when the Taylor number of the molten liquid in the crucible is so high as to give a strong action of Coriolis force, the effect of the present invention can be exerted remarkably, making it possible to perform higher crystal growth.

Brief Description of the Drawings

Fig. 1 is a schematic diagram of a CZ method crystal growth furnace;

Fig. 2A, B are typical diagrams of molten liquid flow structure in a crucible for CZ method crystal growth;

Fig. 3 is a schematic diagram illustrating the relationship between the change of the thickness of a molten liquid layer and the extension of vortex in a CZ method crucible;

Fig. 4A, 4B are diagrams illustrating distribution pattern of vortex and temperature on the surface of a molten liquid during silicon crystal growth obtained by numerical simulation;

Fig. 5 is a diagram illustrating various profiles of crucible bottom and crystal interface studied by numerical simulation;

Fig. 6 is a diagram illustrating the relationship between the height of raised portion formed on the inner bottom surface of the crucible of Claim 1 and dT/dR;

Fig. 7 is a diagram illustrating the profile of a longitudinal section of the crucible of Comparison Example 1;

Fig. 8 is a diagram illustrating the radial change of the thickness of a molten liquid layer during the growth of silicon crystal in the crucible of Fig. 7;

Fig. 9 is a diagram illustrating a longitudinal section of the inventive crucible of Example 1;

Fig. 10 is a diagram illustrating the radial change of the thickness of the molten liquid layer during the growth of silicon crystal in the crucible having the structure shown in Fig. 9;

Fig. 11 is a diagram illustrating the relationship between the crystal growth rate and the width of crystal deformation at a Taylor number of $9.2 \times 10^8$ in the case where the inventive crucible of Example 1 and the crucible of Comparison Example 1 of Fig. 7 are used; and

Fig. 12 is a diagram illustrating the relationship between the crystal growth rate and the width of crystal deformation at a Taylor number of $3.0 \times 10^9$ in the case where the inventive crucible of Example 1 and the crucible of Comparison Example 1 of Fig. 7 are used.

Description of Reference Numerals and Signs

| | |
|---|---|
| 1 | Susceptor |
| 2 | Crucible |
| 3 | Heater |
| 4 | Molten liquid |
| 5 | Seed crystal |
| 6 | Crystal |
| 8 | Insulating material |
| 9 | Furnace |
| 10 | Insulating material |
| 20 | Crystal driving mechanism |
| 21 | Wire |
| 22 | Cochran boundary layer |
| 23 | Direction of rotation of crystal |
| 24 | Rigid body rotation region |
| 25 | Direction of rotation of crucible |
| 26 | Interlayer |
| 27 | Central axis of rotation |
| 28 | Crystal growth interface |
| 29 | Free surface of molten liquid |
| 30 | Bottom of crucible |
| 31, | 32, 33 Vortex tube |
| 34 | Side wall of crucible |
| 35 | Height of bottom of crucible |
| 36 | Thickness of molten liquid layer |
| 37 | Level of molten liquid |
| 38 | Periphery of crystal |
| 39 | Curve illustrating the relationship between the crystal growth rate and the width of crystal deformation of comparison example |
| 40 | Curve illustrating the relationship between the crystal growth rate and the width of crystal deformation of Example 1 of the present invention |
| 41 | Curve illustrating the relationship between the crystal growth rate and the width of crystal deformation of Comparison Example 1 |
| 42 | Curve illustrating the relationship between the crystal growth rate and the width of crystal deformation of Example 1 of the present invention |

**Claims**

1. A process for the growth of a silicon crystal by the Czochralski method which comprises using a crucible having an inner bottom surface the profile of which has at least a raised portion symmetrical about the rotation axis of the crucible wherein the periphery of the raised portion is positioned at a distance from the rotation axis of from 0.4 to 1.2 times the radius of the crystal to be grown and wherein the height of the raised portion is from not smaller than 7 % to not greater than 100 % of the radius of the crystal to be grown.

2. A process according to claim 1 wherein the raised portion has a height of not greater than half the radius of the crystal to be grown and wherein during the growth of the regular shape portion of the crystal, the vertical thickness of a molten silicon layer taking into account the expanded shape of the interface of the molten silicon layer with the crystal does not increase toward the rotation axis of the crucible within a distance from the rotation axis of from at least 0.8 to 1.2 times the radius of crystal to be grown.

3. A process according to claim 2 wherein the height of the inner bottom surface of the crucible does not decrease toward the rotation axis within a distance from the rotation axis to the radius of the crystal to be grown.

**4.** A process according to any one of claims 1 to 3 wherein the rotation speed of the crucible during the growth of the crystal is predetermined such that the Taylor number of the molten silicon is not smaller than 1.0 x 10$^9$.

## Patentansprüche

**1.** Verfahren für die Züchtung eines Siliciumkristalls durch das Czochralski-Verfahren, das das Verwenden eines Tiegels mit einer inneren Bodenfläche umfasst, deren Profil mindestens einen erhöhten Teil aufweist, der symmetrisch um die Rotationsachse des Tiegels ist, wobei die Peripherie des erhöhten Teils in einem Abstand von der Rotationsachse von 0,4- bis 1,2-mal dem Radius des zu züchtenden Kristalls positioniert ist und wobei die Höhe des erhöhten Teils von nicht kleiner als 7 % bis nicht größer als 100 % des Radius des zu züchtenden Kristalls beträgt.

**2.** Verfahren nach Anspruch 1, wobei der erhöhte Teil eine Höhe von nicht größer als die Hälfte des Radius des zu züchtenden Kristalls aufweist, und wobei während der Züchtung des Teils des Kristalls mit regelmäßiger Form die vertikale Dicke einer geschmolzenen Siliciumschicht, die die expandierte Form der Grenzfläche der geschmolzenen Siliciumschicht mit dem Kristall berücksichtigt, nicht in Richtung der Rotationsachse des Tiegels innerhalb eines Abstands von der Rotationsachse von mindestens 0,8- bis 1,2-mal dem Radius des zu züchtenden Kristalls zunimmt.

**3.** Verfahren nach Anspruch 2, wobei die Höhe der inneren Bodenfläche des Tiegels nicht in Richtung der Rotationsachse innerhalb eines Abstands von der Rotationsachse zu dem Radius des zu züchtenden Kristalls abnimmt.

**4.** Verfahren nach einem beliebigen der Ansprüche 1 bis 3, wobei die Rotationsgeschwindigkeit des Tiegels während der Züchtung des Kristalls derartig vorbestimmt ist, dass die Taylor-Zahl des geschmolzenen Siliciums nicht kleiner ist als 1,0 x 10$^9$.

## Revendications

**1.** Procédé pour la croissance d'un cristal de silicium par la méthode de Czochralski qui comprend l'utilisation d'un creuset ayant une surface inférieure interne dont le profil comporte au moins une partie soulevée symétrique par rapport à l'axe de rotation du creuset dans lequel la périphérie de la partie soulevée est positionnée à une distance de l'axe de rotation égale à 0,4 à 1,2 fois le rayon du cristal à faire croître et dans lequel la hauteur de la partie soulevée va de pas moins de 7 % à pas plus de 100 % du rayon du cristal à faire croître.

**2.** Procédé selon la revendication 1 dans lequel la partie soulevée possède une hauteur ne dépassant pas la moitié du rayon du cristal à faire croître et dans lequel, lors de la croissance de la partie de forme régulière du cristal, l'épaisseur verticale d'une couche de silicium fondu tenant compte de la forme dilatée de l'interface de la couche de silicium fondu avec le cristal n'augmente pas vers l'axe de rotation du creuset sur une distance depuis l'axe de rotation représentant au moins 0,8 à 1,2 fois le rayon du cristal à faire croître.

**3.** Procédé selon la revendication 2 dans lequel la hauteur de la surface inférieure interne du creuset ne diminue pas vers l'axe de rotation sur une distance de l'axe de rotation au rayon du cristal à faire croître.

**4.** Procédé selon l'une quelconque des revendications 1 à 3 dans lequel la vitesse de rotation du creuset pendant la croissance du cristal est prédéterminée de telle sorte que le nombre de Taylor du silicium fondu ne soit pas inférieur à 1,0x10$^9$.

**Fig. 1**

## Fig: 2A

## Fig: 2B

Fig. 3

*Fig. 4A*

*Fig. 4B*

_Fig. 5_

Fig. 6

## Fig. 7

## Fig. 8

## Fig. 9

350mm

R70mm

R350 mm

2

10mm

120mm

## Fig. 10

120

100

80

60

40

20

0

(mm)

37    38

36

35

160  140  120  100  80   60   40   20   0

(mm)

## Fig. 11

## Fig. 12

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 63256593 A
- JP 8239291 A
- JP 11092272 A
- GB 2207617 A
- DE 19902302 A1

**Non-patent literature cited in the description**

- *Shin-nittetsu Giho,* 29 September 2000, (373), 2
- **TORU YOSHIZAWA.** Ryutai Rikigaku (Fluidynamics. *Tokyo Daigaku Shuppankai,* 05 September 2001, 75